# FASCICULE DE BREVET EUROPEEN

(11) **EP 2 143 189 B1**
(45) Date de publication et mention de la délivrance du brevet: **17.12.2014**
(21) Numéro de dépôt: 08805551.2
(22) Date de dépôt: 07.05.2008
(51) Int. Cl.: H02K 5/22, H05K 3/30, G12B 11/00

(54) **MODULE INDICATEUR DE TABLEAU DE BORD FORMÉ D'UN MOTEUR ET DE MOYENS DE CONNEXION ÉLECTRIQUE**
AUS EINEM MOTOR UND ELEKTRISCHEN ANSCHLUSSMITTELN GEFORMTE ARMATURENBRETTANZEIGEMODULE
DASHBOARD INDICATOR MODULE FORMED BY A MOTOR AND ELECTRICAL CONNECTION MEANS

(30) Priorité: 09.05.2007 FR 0754937; 03.10.2007 FR 0706930
(43) Date de publication de la demande: 13.01.2010
(73) Titulaire: Sonceboz Automative SA, 2605 Sonceboz (CH)
(72) Inventeur: STRAHM, Martin, CH-2017 Boudry (CH); GEISER, Michael, CH-2710 Tavannes (CH); GANDEL, Pierre, F-25660 Montfaucon (FR); LOUSSERT, Guillaume, F-25000 Besançon (FR)
(74) Mandataire: Fidal Innovation
(86) Numéro de dépôt international: PCT/FR2008/000646
(87) Numéro de publication internationale: WO 2008/152240

(56) Documents cités:
- EP-A- 1 164 052
- FR-A- 2 744 680
- FR-A- 2 782 596
- FR-A- 2 885 739
- GB-A- 1 076 490
- GB-A- 2 221 098
- JP-A- 10 032 040
- US-A- 5 446 326

## Description

La présente invention concerne le domaine des indicateurs pour tableau de bord automobile et présente plus particulièrement un module constitué d'un moteur et de moyens de connexion électriques, appelés connecteurs ou contacts, destiné à être fixé sur un circuit imprimé qui comprend tous les composants électroniques nécessaires au fonctionnement du moteur.

Généralement, les aiguilles indicatrices de tableau de bord (tachymètre, jauge...) pour automobile sont actionnées par des petits moteurs électromagnétiques, dits pas à pas. De tels moteurs sont, par exemple, présentés dans le brevet FR 2742940 ou le brevet FR 2859323. Ces moteurs sont fixés au tableau de bord, derrière celui-ci, sur un circuit imprimé sur lequel sont aussi disposées les pistes d'alimentation électrique et tous les composants électroniques destinés à faire fonctionner le moteur. Le circuit imprimé est fixé dans l'instrument du tableau de bord et le moteur est fixé au circuit imprimé. La connexion électrique du moteur est généralement réalisée grâce à la soudure des pattes de connexion électrique solidaires du moteur avec les pistes du circuit imprimé. Il peut aussi être envisagé de souder des connecteurs au circuit imprimé et de venir placer les pattes de connexion du moteur dans ces connecteurs. Le brevet FR 2885739 de la demanderesse décrit une méthode de ce type.

Néanmoins, toutes ces méthodes de l'art antérieur présentent certains désavantages :
- Il faut placer les connecteurs sur le circuit imprimé d'une part, et placer le boîtier contenant le moteur sur le circuit imprimé d'autre part. Il faut donc placer les connecteurs au circuit imprimé puis le boîtier sur le circuit imprimé et connecter le boîtier aux connecteurs.
- Ces techniques de l'art antérieur ne permettent pas le retrait facile et la réutilisation du moteur sur un autre circuit imprimé avec les mêmes moyens de connexion électrique de façon simple et immédiate.

Il existe déjà des solutions dans l'art antérieur qui montrent des moteurs ayant des pattes de connexion de formes incurvées et déformables. Lors du posage du moteur sur le circuit imprimé, ces pattes de connexion particulières viennent en contact avec des zones surface de contact électrique sur le circuit imprimé et se déforment afin d'assurer le contact électrique. Il n'y a ainsi pas de soudure du moteur au circuit.

Cependant, ces solutions nécessitent la réalisation d'une solution originale de moteur devant présenter des pattes de connexion bien particulières. Ceci nécessite de réaliser un produit différent en parallèle d'une solution classique avec moteur à pattes de connexion droites et nécessitant des soudures sur le circuit imprimé. En fonction de l'application ou du client cible, les outils de production sont doubles et l'ensemble de deux moteurs onéreux à produire.

La présente invention se propose de remédier à ce problème en revendiquant un module de moteur électrique pouvant être indifféremment utilisé avec soudure des pattes de connexion sur le circuit imprimé ou sans soudure en utilisant des contacts rapportés sur les pattes de connexion, en fonction du type de connexion demandée par le client.

Plus particulièrement, l'objet de la présente invention est de proposer un module indicateur de tableau de bord comprenant dans un boîtier un moteur rotatif, un arbre de sortie, des moyens de réduction mécanique liés au moteur, au moins une bobine d'alimentation électrique, des pattes de connexion électrique liées aux bobines sortant dudit boîtier et des éléments de contact électrique caractérisé en ce que lesdits éléments de contact peuvent être montés sur les pattes de connexion afin de réaliser une connectique sans soudure au circuit imprimé ou bien retirés des pattes de connexion afin de permettre la soudure directe des pattes de connexion du moteur au circuit imprimé.

Un autre des objets de l'invention est de présenter des éléments de contact électrique composés d'une première partie en liaison mécanique et électrique avec lesdites pattes et une deuxième partie libre destiné à venir en contact mécanique et électrique avec une zone surface alimentée en tension d'un circuit imprimé qui supporte ledit module et qui sert à alimenter ledit moteur en tension.

Un autre des objets de la présente invention est de proposer un module comprenant un moteur et des contacts électriques solidaires du moteur qui ne nécessite pas de soudure du moteur au circuit imprimé ni de soudure au niveau du circuit imprimé entre le moteur et ledit circuit et permettant le retrait facile du moteur placé sur le circuit imprimé.

Un autre des objets de la présente invention est aussi de proposer un module comprenant un moteur, des contacts électriques et des rivets mécaniques totalement indépendants du circuit imprimé et pouvant s'adapter à plusieurs circuits imprimés de natures différentes.

Ainsi, le circuit imprimé destiné à recevoir le module indicateur décrit par l'invention n'a plus à présenter de moyens de fixation électrique ou mécanique et n'a plus qu'à présenter, outre les composants électriques nécessaire au pilotage du moteur, des perçages afin de permette le passage des contacts électriques et mécaniques du module.

Concrètement, le moteur présente des pattes de connexion électrique classiques sous la forme d'axes ou d'épingles et des contacts électriques qui sont fixés chassés mécaniquement sur ces pattes. Il peut éventuellement être envisagé de souder ces contacts aux pattes.

La forme des contacts électriques peut être quelconque, par exemple de forme spirale, mais ils doivent comporter une première partie qui assure le contact électrique de cet élément sur la patte de connexion du moteur, et une deuxième partie dirigée vers le circuit imprimé pour entrer en liaison avec la zone de connexion électrique du circuit imprimé. La forme de ce contact doit aussi permettre sa déformation lors du posage du moteur sur le circuit imprimé.

Le maintien mécanique du moteur sur le circuit imprimé peu être assuré par des rivets déformables bien connus dans les documents de l'art antérieur ou par tout autre méthode à la disposition de l'Homme de Métier.

Lors de la fixation mécanique du moteur, les éléments de contact électrique se déforment et agissent comme un ressort. A l'équilibre en position comprimée, une force est donc appliquée sur le circuit imprimé et sur le boîtier du moteur. Puisque les rivets assurent le maintien mécanique du moteur sur le circuit imprimé, cette force appliquée par le ressort assure donc la qualité du contact électrique.

Ainsi on dispose d'un module moteur + contact électrique sûr et indépendant pouvant s'adapter à divers circuits imprimés et pouvant être placé et enlevé du circuit imprimé à volonté.

Idéalement, mais de façon non limitative, le moteur peut présenter des cavités au voisinage de ses pattes de connexion électrique afin de permettre la plaquage de la face inférieure du boîtier du moteur sur le circuit imprimé. Le module peut aussi présenter des plots sur lesquels s'appuie le moteur. Avec l'une ou l'autre solution, le moteur est ainsi fixé de façon stable au circuit imprimé et sera insensible aux vibrations éventuelles pendant fonctionnement.

La compréhension de l'invention sera facilitée en se référant aux dessins ci-joints dans lesquels :
- la figure 1 présente une vue en coupe d'un module de l'art antérieur,
- la figure 2 présente un exemple d'un module suivant l'invention, formé d'un moteur dans son boîtier et des contacts électriques liés aux pattes de connexion du moteur,
- la figure 3 présente un circuit imprimé destiné à recevoir le module présenté en figure 2,
- la figure 4 présente un exemple de contact électrique utilisé dans le module de l'invention dans un état non déformé,
- la figure 5 présente un exemple de contact électrique utilisé dans le module de l'invention suivant la figure 3 dans un état déformé,
- la figure 6 présente une vue du dessous du module où le contact présenté en figure 4 et 5 est fixé sur une patte de connexion électrique du moteur,
- la figure 7 présente un autre exemple de contact électrique utilisé dans le module de l'invention dans un état non déformé,
- la figure 8 présente un autre exemple de contact électrique utilisé dans le module de l'invention suivant la figure 7 dans un état déformé,
- la figure 9 présente un autre exemple de contact électrique utilisé dans le module de l'invention,
- la figure 10 est une vue en coupe d'un module suivant l'invention comprenant des contacts comme présentés en figures 4, 5 et 6 en approche d'un circuit imprimé,
- la figure 11 est une vue en coupe d'un module suivant l'invention comprenant des contacts comme présentés en figures 4, 5 et 6 en contact avec un circuit imprimé,
- la figure 12 est une vue en coupe d'un module suivant l'invention comprenant des contacts comme présentés en figures 7 et 8 en approche d'un circuit imprimé,
- la figure 13 est une vue en coupe d'un module suivant l'invention comprenant des contacts comme présentés en figures 7 et 8 en contact avec un circuit imprimé,
- la figure 14 est une vue en coupe d'un module suivant l'invention comprenant des contacts comme présentés en figure 9 en approche d'un circuit imprimé,
- la figure 15 est une vue en coupe d'un module suivant l'invention comprenant des contacts comme présentés en figure 9 en contact avec un circuit imprimé,
- la figure 16 est un circuit imprimé destiné à recevoir un module suivant l'invention présentant des contacts comme présentés en figure 9,
- les figures 17a et 17b présentent un autre exemple de contact électrique utilisé dans le module de l'invention,
- la figure 18 est une vue en coupe d'un module suivant l'invention comprenant des contacts comme présentés en figures 17a et 17b en approche d'un circuit imprimé,
- la figure 19 est une vue en coupe d'un module suivant l'invention comprenant des contacts comme présentés en figures 17a et 17b en contact avec un circuit imprimé.

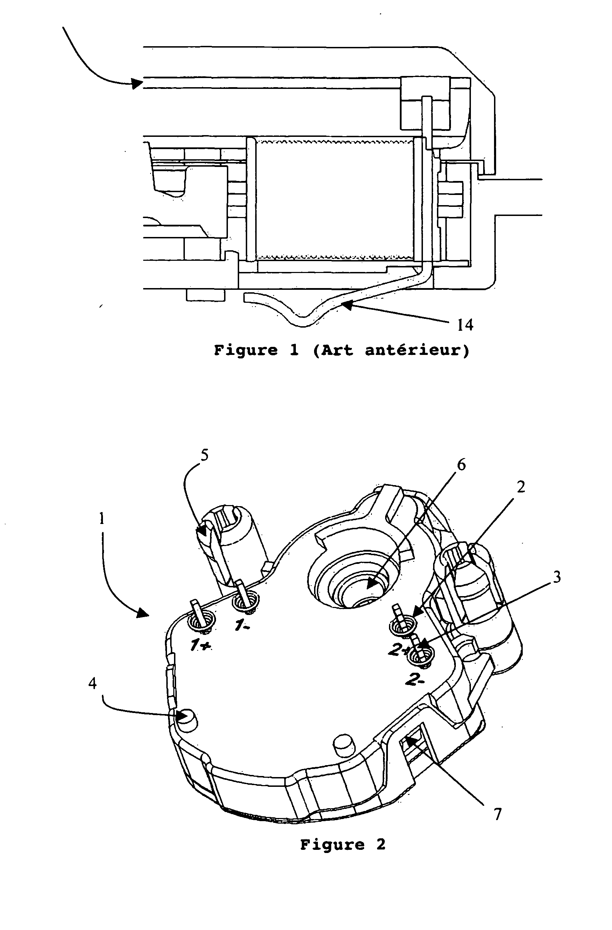

La figure 1 présente une réalisation de l'art antérieur. Il comprend un moteur, de type électromagnétique par exemple, dans un boîtier (7b) et présente des pattes de connexion électrique (14) liées aux bobines du moteur, de forme non linéaire et ici en forme de lettre J. Ce moteur est destiné à être fixé sur un circuit imprimé et ces pattes de connexion (14) à se déformer pour assurer un contact électrique sûr avec ce circuit imprimé. Cependant, ce mode de réalisation nécessite un produit bien différent de celui, plus classique, utilisant des pattes de connexion droites devant être soudées au circuit imprimé. Ainsi, suivant l'une ou l'autre utilisation, deux modules doivent être fabriqués indépendamment.

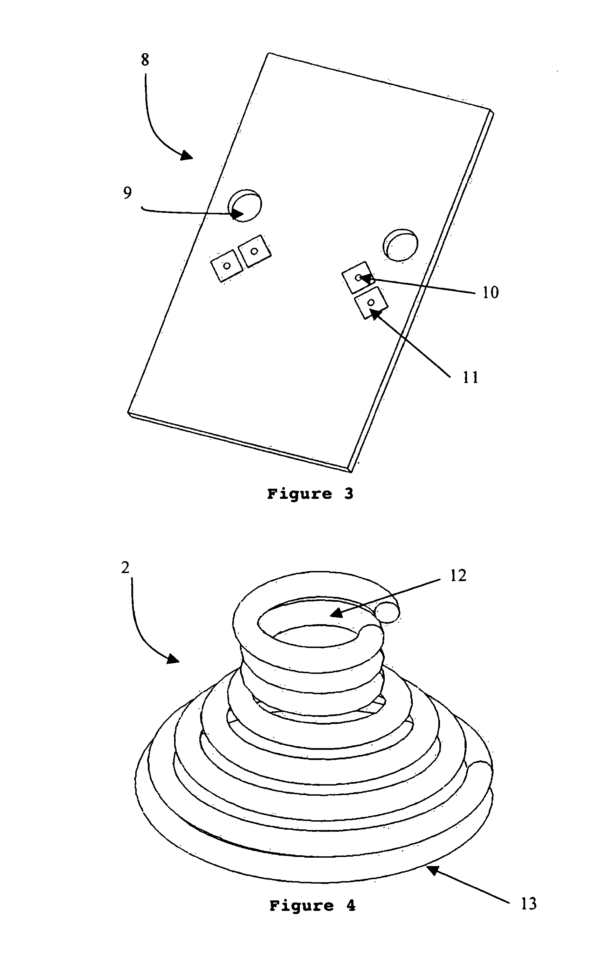

La figure 2 présente un module (1) suivant l'invention. Il est composé d'un boîtier plastique clipsé (7) contenant un moteur, typiquement électromagnétique, et un train d'engrenage réducteur déplaçant en rotation un axe(6), par exemple creux, destiné à recevoir une aiguille indicatrice. Cette aiguille servira à donner, sur un tableau de bord automobile, une information de vitesse, de niveau ou d'un autre paramètre. Ce boîtier (7) comprend de façon préférentiel deux rivets déformables (5) qui servent à la tenue mécanique du boîtier (7) sur le circuit imprimé (8) destiné à le recevoir. Il comprend aussi des plots d'appui (4) sur lesquels le module (1) repose sur le circuit imprimé (8) et des pattes de connexion électrique (3) classiques, droites. Ces pattes de connexion (3) sont en fait les connexions électriques des bobines du moteur électromagnétique à l'intérieur du boîtier (7) et sont donc, par exemple pour un moteur diphasé à deux bobines, sous la forme de deux paires de pattes (3). Sur ces pattes (3) sont fixés des contacts électriques (2), chassés mécaniquement ou soudés. Ce module (1) est destiné à être placé sur un circuit imprimé (8) comme présenté en figure 3. En retirant les contacts (2) des pattes (3), le module (1) peut aussi être connecté au circuit imprimé (8) en soudant directement les pattes (3) au circuit imprimé (8).

Typiquement, ce circuit imprimé (8) présente, outre tous les éléments électroniques nécessaires au pilotage du moteur, une première série de perçages (9) destiné à recevoir les rivets mécaniques (5) déformables. Une fois ces rivets (5) placés au travers des perçages (9) ils sont déformés pour assurer le maintien solide du module (1) sur le circuit imprimé (8). Ce circuit (8) présente aussi une deuxième série de perçages (10) destiné à recevoir les pattes de connexion électrique (3). Ces dernières passent au travers des perçages (10) sans contact physique. Au voisinage de ces perçages sont placés des zones surface de contact (11) qui reçoivent les contacts (2) du module (1). Lors du placement du module (1) sur le circuit imprimé (8), les rivets (5) assurent le maintien mécanique, les plots d'appui (4) assurent la stabilité et les contacts (2), qui doivent préférentiellement avoir des propriétés élastiques, se déforment afin de garantir par effet ressort le contact électrique entre les pattes de connexion (3) et la zone surface de contact (11). Sans les contacts (2), les pattes (3) du module (1) sont directement soudées sur les zones surface de contact (11).

La figure 4 présente un élément de contact (2) dans un premier mode de réalisation et dans un état libre non déformé. Dans ce premier mode de réalisation, ce contact (2) prend la forme d'un ressort de forme conique et hélicoïdale et comprend deux parties notables. La première partie (12), est destinée à assurer son maintien à la patte de connexion (3), soit par chassage mécanique soit éventuellement par soudure.

La deuxième partie (13) est destinée à assurer le contact électrique avec la zone surface de contact (11) du circuit imprimé (8).

Lors du placement du module (1) sur le circuit imprimé (8), ce contact (2) se déforme et assure ainsi, par les forces d'action et réaction, la qualité du contact électrique en le circuit imprimé (8) et le moteur du module (2).

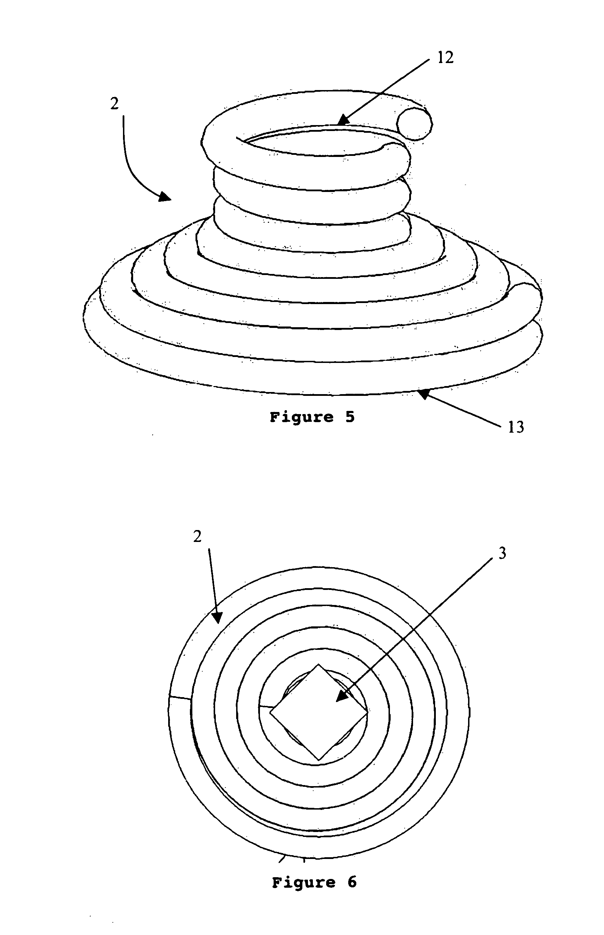

La figure 5 montre ce même module (2) suivant la figure 4 mais dans un état déformé comme il doit être après montage du module (2) sur le circuit imprimé (8). La deuxième partie (13) doit alors être en contact avec la zone surface de contact (11) du circuit imprimé (8) et les spires du contact (2) sont alors rapprochés les unes des autres, éventuellement en configuration de spires jointives.

Lorsque le contact (2) est monté sur la patte de connexion (3) on peut ainsi voir par le dessous du module l'association patte (3) + contact (2) comme en figure 6. La patte de connexion (3) est en contact physique avec l'élément de contact (2) au niveau de la première partie (12) décrite précédemment.

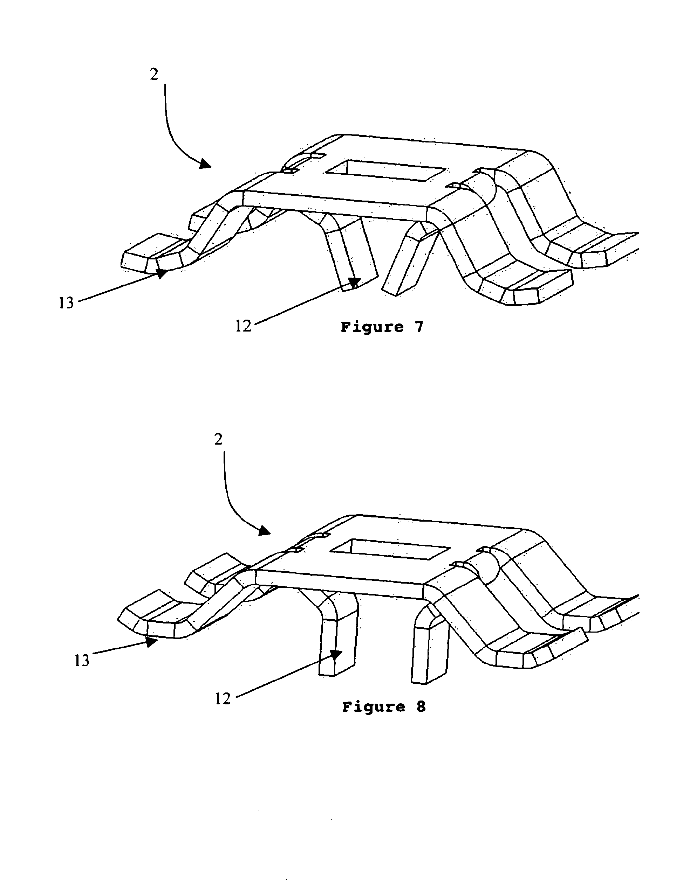

La figure 7 présente un élément de contact (2) dans un deuxième mode de réalisation. Il doit préférentiellement présenté, comme dans tous les modes de réalisation, des propriétés élastiques et présenter deux parties distinctes (12) et (13) destinées à venir en contact respectivement avec la patte de connexion (3) du moteur et avec la zone surface de contact électrique (11) du circuit imprimé (8). Sur cette figure 7, l'élément de contact (2) est dans un état libre non déformé. La figure 8 présente ce même élément de contact (2) dans un état déformé comme se présentant après montage du module sur le circuit imprimé.

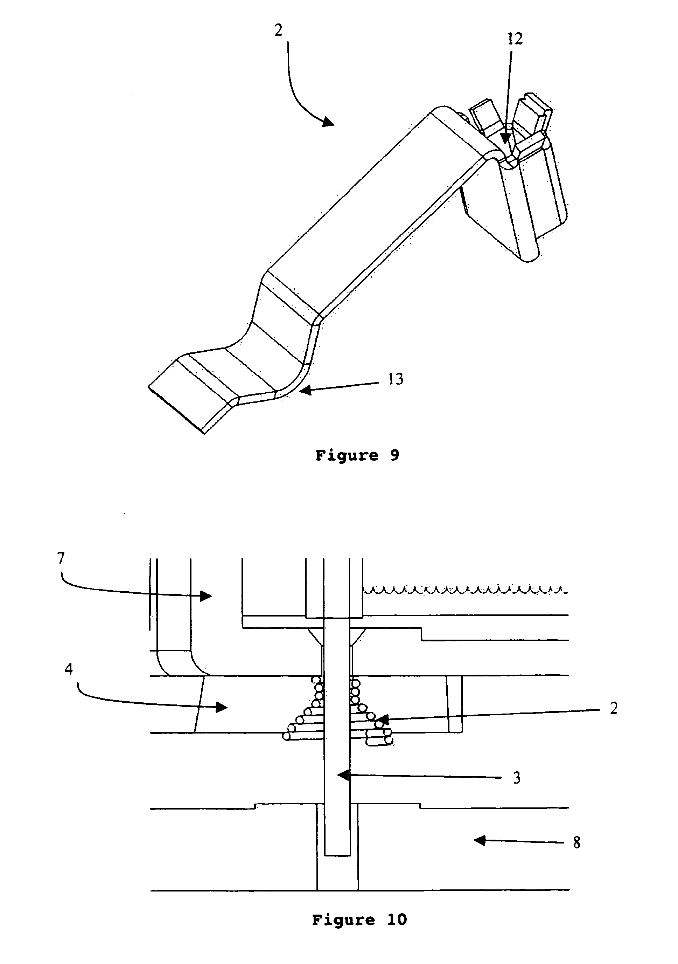

La figure 9 présente un élément de contact dans un troisième mode de réalisation avec, de même, les deux parties caractéristiques (12) et (13) nécessaires au bon fonctionnement du contact.

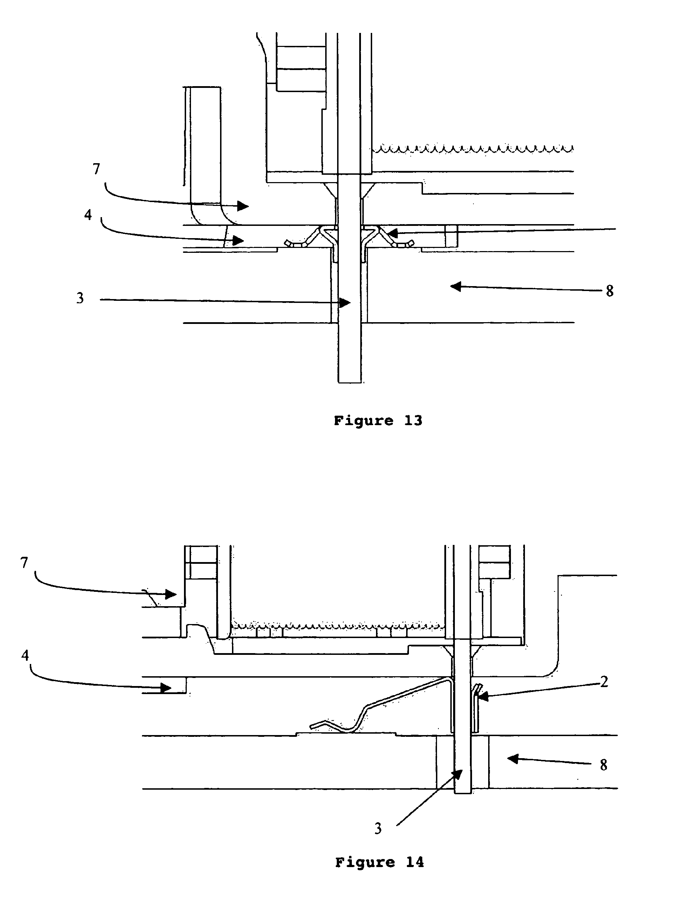

Les figures 10 à 15 présentent des vues en coupe du module en approche ou en contact du circuit imprimé.

Sur les figures 10, 12 et 14, le module est en approche du circuit imprimé (8) avant montage. Le contact (2) est placé solidaire de la patte de connexion (3) et cette patte (3) commence à traverser le perçage (10) du circuit imprimé (8).

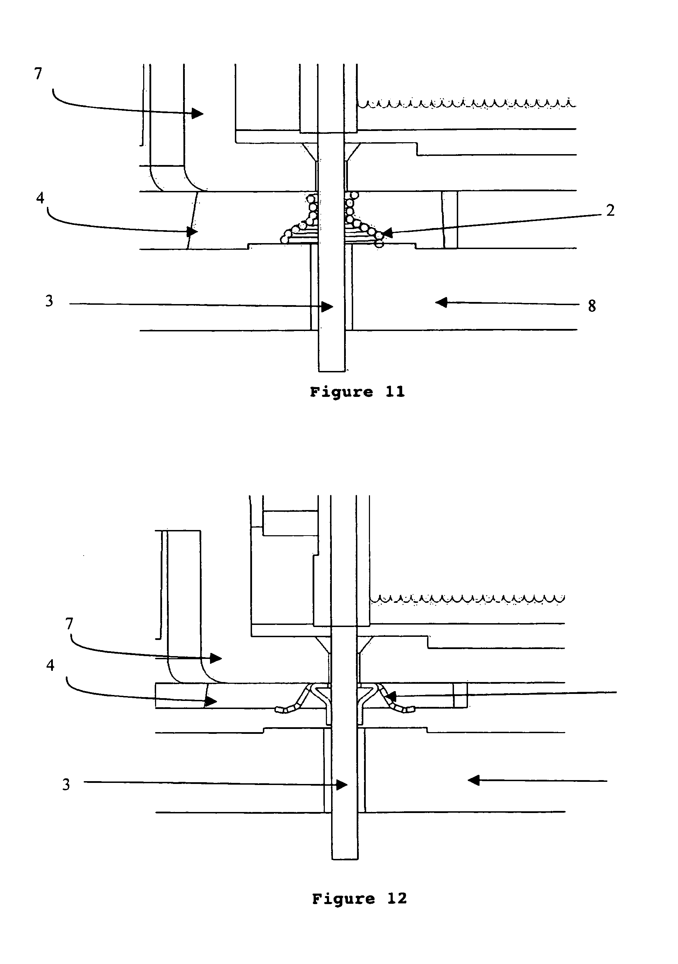

Sur les figures 11, 13 et 15, le module est monté sur le circuit imprimé (8). Les plots d'appui (4) sont en contact avec le circuit imprimé (8) et les éléments de contact (2) sont en état déformé et assurent par mise sous tension mécanique de ces éléments de contact (2) la qualité de l'alimentation électrique du moteur.

En retirant les contacts (2) des pattes (3), ces dernières peuvent alors être directement soudés au circuit imprimé (8).

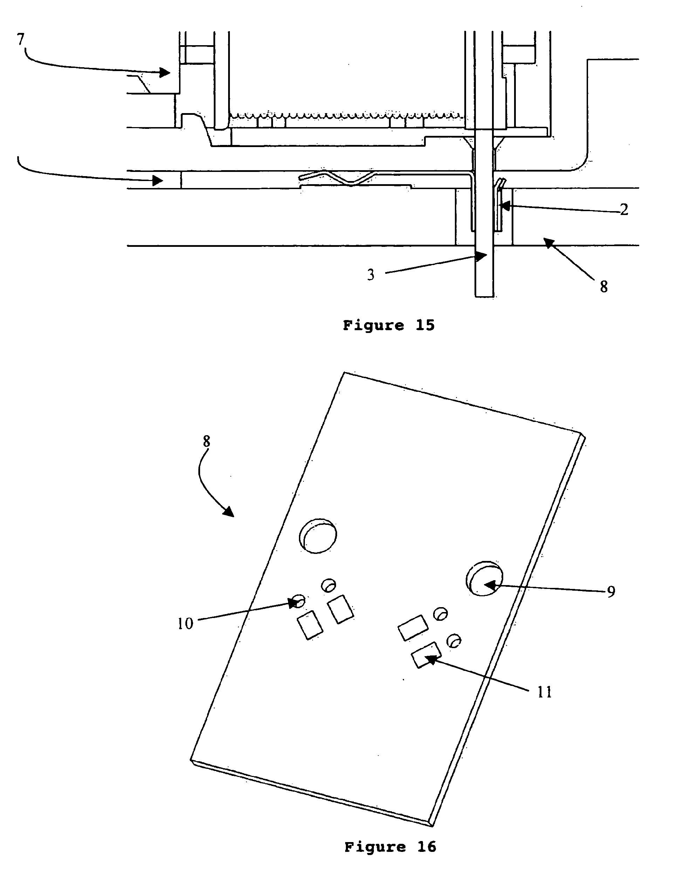

La figure 16 présente le circuit imprimé (8) destiné à recevoir l'élément de contact (2) dans le troisième mode de réalisation présenté en figures 9, 14 et 15.

On retrouve les mêmes éléments que sur le circuit imprimé présenté en figure 3 qui est destiné à recevoir des éléments de contact dans le premier et deuxième mode de réalisation. Ce qui différentie les circuits imprimés de la figure 3 et 16 est la position relative des perçages (10) pour passage des pattes (3) et des zones surface de contact (11). Sur le circuit imprimé de la figure 3, les perçages (10) sont au milieu de la zone surface de contact (11) de par la configuration des éléments de contact (2) dans le premier et deuxième mode de réalisation alors que le circuit imprimé (8) de la figure 16 présente des perçages (10) qui sont à côté de la zone surface de contact (11) de part la configuration des éléments de contact (2) dans le troisième mode de réalisation.

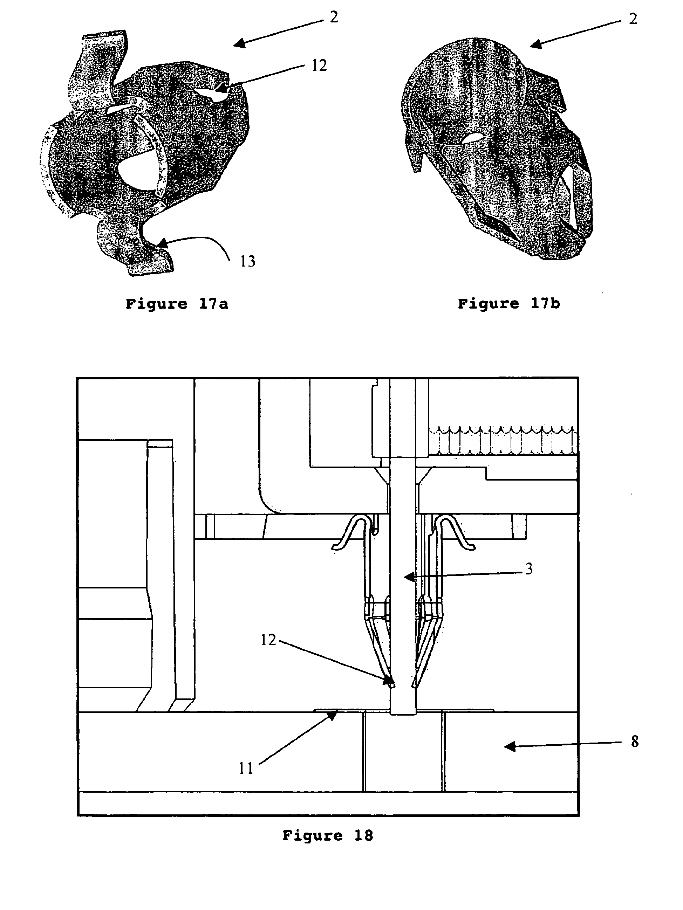

Les figures 17a et 17b présentent un autre exemple de contact électrique (2) sous une forme tubulaire, permettant un montage facile sur le circuit imprimé (8), où l'on retrouve une première partie (12) destinée à entrer en contact avec la patte de connexion (3) par effet ressort, et une deuxième partie (13) assurant le contact électrique avec le circuit imprimé (8) sous la forme d'ailes, le nombre de ces ailes pouvant être variable et de formes différentes comme on le voit en figure 17a et 17b.

La figure 18 présente ce contact (2) monté sur une patte de connexion électrique (3) dans une vue en coupe en approche du circuit imprimé (8).

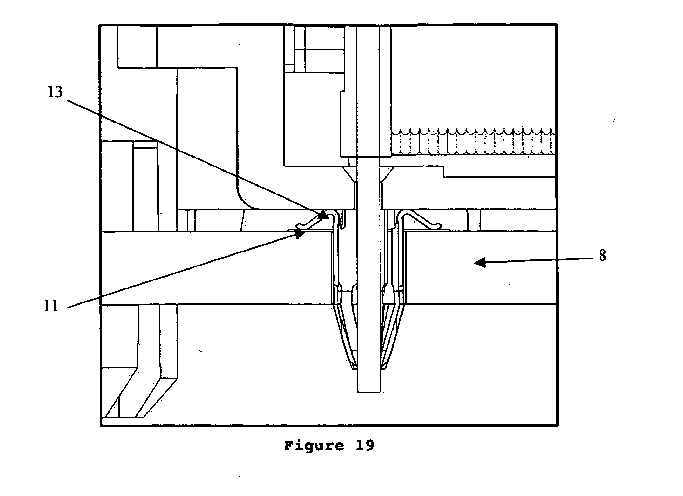

La figure 19 présente le contact (2) monté sur la patte de connexion électrique (3) et installé sur le circuit imprimé (8). La géométrie de ce contact (2) est telle qu'il repose, grâce à ces ailes (13), d'une part sur le boîtier (7) sur la partie supérieure des ailes (13) et d'autre part sur la zone de contact électrique (11) sur sa partie inférieure. Les efforts radiaux sont ainsi encaissés, lors du montage du contact (2) au niveau du boîtier (7).

Un autre avantage de ce contact (2) est de pouvoir réaliser le contact électrique soit par le contact des ailes (13) sur les zones de contact électrique (11) du circuit imprimé (8) soit par la connexion du corps du contact (2) sur l'intérieur du perçage (10), qui est alors métallisé, ce qui destine ce contact (2) aussi bien a des circuits imprimés (8) simple face que double face.

Enfin, un autre avantage de ce contact (2) des figures 17a et 17b est d'être circulaire ce qui garantit que les efforts causés par les micro-vibrations lors du fonctionnement, sont essentiellement des efforts axiaux et non radiaux, permettant au contact (2) d'assurer sa fonction dans le temps sans causer d'oxydation précoce.

Les illustrations présentées dans ce document sont des exemples de réalisation et ne représentent en aucun cas des modes de réalisation limitatifs. Il est bien sûr envisageable de modifier la forme des éléments de contact (2) ou de tout autre élément présenté dans ce document sans sortir de l'objet de l'invention, tel que défini dans les revendications.

## Revendications

1. Module (1) indicateur de tableau de bord comprenant dans un boîtier (7) un moteur rotatif, un arbre de sortie, des moyens de réduction mécanique liés au moteur, au moins une bobine d'alimentation électrique, des pattes de connexion (3) électrique liées aux bobines sortant dudit boîtier (7) et des éléments de contact (2) électrique **caractérisé en ce que** lesdits éléments de contact (2) électrique peuvent être montés sur les pattes de connexion (3) afin de réaliser une connectique sans soudure au circuit imprimé (8) ou bien retirés des pattes de connexion (3) afin de permettre la soudure directe des pattes de connexion (3) du moteur au circuit imprimé (8).

2. Module (1) indicateur de tableau de bord la revendication 1 **caractérisé en ce que** lesdits éléments de contact (2) présentent une première partie (12) en liaison mécanique et électrique avec lesdites pattes et une deuxième partie (13) libre destiné à venir en contact mécanique et électrique avec une zone surface (11) alimentée en tension d'un circuit imprimé (8) qui supporte ledit module (1) et qui sert à alimenter ledit moteur en tension.

3. Module (1) indicateur de tableau de bord suivant l'une des revendications précédentes **caractérisé en ce que** lesdits contacts (2) présentent un caractère mécanique de type ressort.

4. Module (1) indicateur de tableau de bord suivant l'une des revendications précédentes **caractérisé en ce que** ledit boîtier (7) présente des rivets déformables (5) formant des protubérances et qui assurent le maintien mécanique du module (1) sur ledit circuit imprimé (8).

5. Module (1) indicateur de tableau de bord suivant l'une des revendications précédentes **caractérisé en ce que** lesdits contacts (2) se déforment lors du posage dudit module (1) sur ledit circuit imprimé (8).

6. Module (1) indicateur de tableau de bord suivant l'une des revendications précédentes **caractérisé en ce que** les éléments de contact (2) sont chassés mécaniquement aux pattes de connexion (3) du moteur.

7. Module (1) indicateur de tableau de bord suivant l'une des revendications précédentes **caractérisé en ce que** les éléments de contact (2) sont soudés aux pattes de connexion (3) du moteur.

8. Module (1) indicateur de tableau de bord suivant l'une des revendications précédentes **caractérisé en ce que** le circuit imprimé (8) présente des perçages (10) métallisés et **en ce que** la connectique sans soudure est réalisée entre le corps de l'élément de contact (2) et le perçage métallisé du circuit imprimé (8).

## Patentansprüche

1. Anzeigemodul (1) eines Armaturenbretts, umfassend in einem Gehäuse (7) einen rotierenden Motor, eine Ausgangswelle, Mittel zur mechanischen Reduktion, die mit dem Motor verbunden sind, wenigstens eine elektrische Versorgungsspule, elektrische Anschlussklauen (3), die mit den Spulen verbunden sind, die aus dem genannten Gehäuse (7) hinaustreten, und elektrische Kontaktelemente (2), **dadurch gekennzeichnet, dass** die genannten elektrischen Kontaktelemente (2) auf den Anschlussklauen (3) montiert sein können, um einen Anschluss ohne Schweißnaht an der gedruckten Leiterplatte (8) zu realisieren oder von den Anschlussklauen (3) abgenommen zu werden, um die direkte Verschweißung der Anschlussklauen (3) des Motors an der gedruckten Leiterplatte (8) zu ermöglichen.

2. Anzeigemodul (1) eines Armaturenbretts gemäß Anspruch 1, **dadurch gekennzeichnet, dass** die genannten Kontaktelemente (2) einen ersten Teil (12) in mechanischer und elektrischer Verbindung mit den genannten Klauen und einen freien zweiten Teil (13) aufweisen, der dazu bestimmt ist, in mechanischen und elektrischen Kontakt mit einem Oberflächenbereich (11) zu treten, der mit der Spannung einer gedruckten Leiterplatte (8) versorgt wird, die das genannte Modul (1) stützt und die zur Versorgung des genannten Motors mit Spannung dient.

3. Anzeigemodul (1) eines Armaturenbretts gemäß einem der voranstehenden Ansprüche, **dadurch gekennzeichnet, dass** die genannten Kontakte (2) ein mechanisches Merkmal vom Typ Feder aufweisen.

4. Anzeigemodul (1) eines Armaturenbretts gemäß einem der voranstehenden Ansprüche, **dadurch gekennzeichnet, dass** das genannte Gehäuse (7) verformbare Nieten (5) aufweist, die Protuberanzen bilden und die den mechanischen Halt des Moduls (1) auf der genannten gedruckten Leiterplatte (8) gewährleisten.

5. Anzeigemodul (1) eines Armaturenbrettes gemäß einem der voranstehenden Ansprüche, **dadurch gekennzeichnet, dass** die genannten Kontakte (2) sich bei der Anbringung des genannten Moduls (1) auf der genannten gedruckten Leiterplatte (8) verformen.

6. Anzeigemodul (1) eines Armaturenbrettes gemäß einem der voranstehenden Ansprüche, **dadurch gekennzeichnet, dass** die Kontaktelemente (2) mechanisch auf die Anschlussklauen (3) des Motors geschoben werden.

7. Anzeigemodul (1) eines Armaturenbrettes gemäß einem der voranstehenden Ansprüche, **dadurch gekennzeichnet, dass** die Kontaktelemente (2) an den Anschlussklauen (3) des Motors verschweißt sind.

8. Anzeigemodul (1) eines Armaturenbrettes gemäß einem der voranstehenden Ansprüche, **dadurch gekennzeichnet, dass** die gedruckte Leiterplatte (8) metallisierte Bohrungen (10) aufweist und dass der Anschluss ohne Schweißnaht zwischen dem Korpus des Kontaktelements (2) und der metallisierten Bohrung der gedruckten Leiterplatte (8) realisiert ist.

## Claims

1. A dashboard indicator module (1) comprising, in a casing (7), a rotary motor, an output shaft, mechanical reduction means bonded to the motor, at least one electrical power supply coil, electrical connection tabs (3) bonded to the coils leading out of said casing (7) and electrical contact elements (2), **characterized in that** said electrical contact elements (2) can be fitted on the connection tabs (3) in order to produce a seamless connection with the printed circuit (8) or even removed from the connection tabs (3) in order to enable the connection tabs (3) of the motor to be directly soldered to the printed circuit (8).

2. A dashboard indicator module (1) according to claim 1, **characterized in that** said contact elements (2) have first portions (12) mechanically and electrically bonded to said tabs and second free portions (13) intended to come into mechanical and electrical contact with a voltage-supplied surface area (11) of a printed circuit (8) which supports said module (1) and which is used for supplying voltage to said motor.

3. A dashboard indicator module (1) according to one of the preceding claims, **characterized in that** said contacts (2) have a mechanical feature of the spring type.

4. A dashboard indicator module (1) according to one of the preceding claims, **characterized in that** said casing (7) is provided with deformable rivets forming protrusions and which provide the mechanical support of the module (1) on said printed circuit (8).

5. A dashboard indicator module (1) according to one of the preceding claims, **characterized in that** said contacts (2) deform when positioning said module (1) on said printed circuit (8).

6. A dashboard indicator module (1) according to one of the preceding claims, **characterized in that** the contact elements (2) are mechanically driven to the connection tabs (3) of the motor.

7. A dashboard indicator module (1) according to one of the preceding claims, **characterized in that** the contact elements (2) are soldered to the connection tabs (3) of the motor.

8. A dashboard indicator module (1) according to one of the preceding claims, **characterized in that** the printed circuit (8) is provided with metallized bores (10) and **in that** the seamless connection is provided between the body of the contact element (2) and the metallized bore of the printed circuit (8).
